# EUROPEAN PATENT SPECIFICATION

(11) **EP 0 736 911 B1**
(45) Date of publication and mention of the grant of the patent: **27.06.2001**
(21) Application number: 96301949.2
(22) Date of filing: 21.03.1996
(51) Int. Cl.: H01L 31/02, G01J 5/30, H01L 37/02, G01J 5/34

(54) **Method of manufacturing an infrared detector**
Verfahren zur Herstellung eines Infrarotdetektors
Methode de fabrication d'un détecteur infrarouge

(30) Priority: 06.04.1995 JP 8146595
(43) Date of publication of application: 09.10.1996
(73) Proprietor: MURATA MANUFACTURING CO. LTD., Nagaokakyo-Shi, Kyoto 617 (JP)
(72) Inventor: Toyoshima, Isao, c/o Murata Manufacturing Co. Ltd., Nagaokakyo-shi, Kyoto-fu (JP); Serikawa, Junichi, c/o Murata Manufacturing Co.Ltd, Nagaokakyo-shi, Kyoto-fu (JP)
(74) Representative: Hillier, Peter

(56) References cited:
- EP-A- 0 175 418
- EP-A- 0 337 692
- EP-A- 0 357 002
- EP-A- 0 558 766
- US-A- 4 598 163
- PATENT ABSTRACTS OF JAPAN vol. 014, no. 292 (E-0944), 25 June 1990 & JP 02 094413 A (SHOEI CHEM IND CO), 5 April 1990,

## Description

The present invention relates to an infrared detector and method of producing the same.

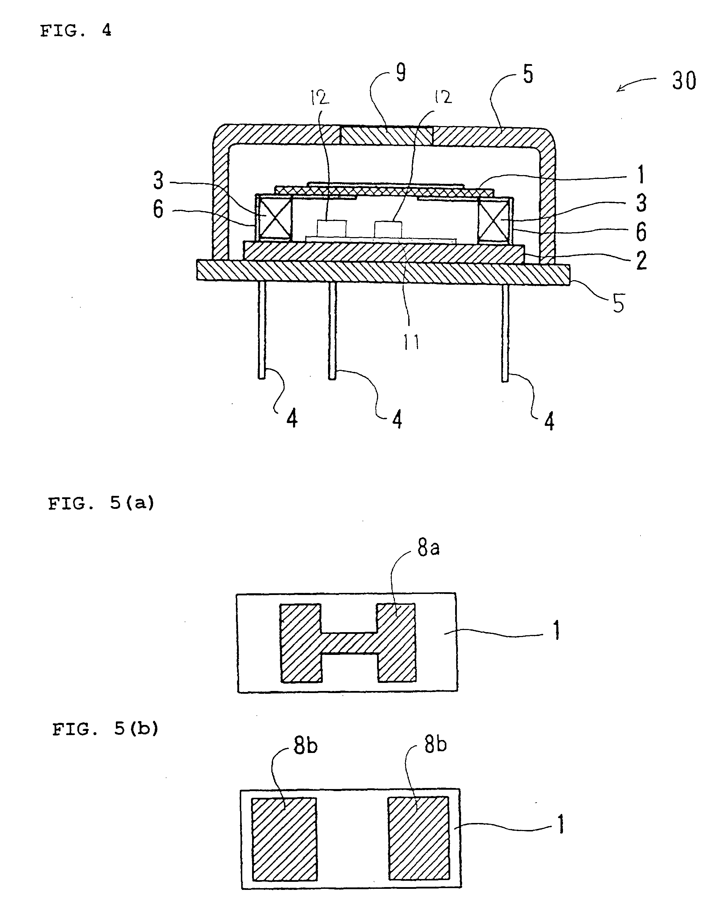

A conventional infrared detector is described with reference to the sectional side view of Fig. 4 and the plan views of Figs. 5(a) and 5(b).

Referring to Fig. 4, an infrared detector 30 comprises an infrared detection element 1, a substrate 2 for supporting the infrared detection element 1 thereon, support members 3 for supporting the infrared detection element 1 on the substrate 2, and output leads 4 for outputting a voltage generated in the infrared detection element 1. The infrared detection element 1 is capped by a case 5.

The substrate 2 comprises ceramic such as alumina, the output leads 4 being attached thereto. A circuit pattern 11 is formed on the front (upper in Fig. 4) surface of the substrate 2 and electronic components 12 such as FETs (field effect transistor), resistors, or the like are provided on the circuit pattern 11, thereby forming a detection circuit for detecting and amplifying the signals detected by the infrared detection element 1.

The support members 3 are of ceramic and have electrodes 6 which are formed on the sides thereof by solder plating. The support members 3 are mounted on the substrate 2 by solder and electrically connected to the output leads 4. The infrared detection element 1 is mounted on the support members 3 by using electrically conductive paste and is electrically connected thereto. Since the support members 3 are provided between the substrate 2 and the infrared detection element 1, a gap is formed between the substrate 2 and the infrared detection element 1. Alternatively, the support members 3 are made of a metal having electrical conductivity.

The infrared detection element 1 has a plate form and is formed using a material selected from glycine sulfate which is an organic material, and lithium tantalate, lead titanate and strontium barium niobate which are inorganic materials. An electrode 8a is formed on the surface of the infrared detection element 1, as shown in Fig. 5(a), and electrodes 8b are formed on the back thereof, as shown in Fig. 5(b).

The infrared detection element 1 which is mounted on the substrate 2 through the support members 3 is contained in the case 5 which has a light transmitting window 9 formed opposite to the infrared detection element 1 and comprising a wavelength selection transmitting film.

When infrared rays passing through the light transmitting window 9 irradiate the infrared detection element 1, the spontaneous polarization of the infrared detection element 1 is changed by a temperature change of the infrared detection element 1, and neutralization of surface charge is broken to output a voltage to the output leads 4.

In a conventional process for producing an infrared detector, the positional relationship between the infrared detection element and the support members, or between the support members and the substrate sometimes deviates. In this case, variations occur due to a heat flow near the electrodes formed on the infrared detection element 1. When infrared rays irradiate the infrared detection element 1, the temperature of the infrared detection element 1 fluctuates due to variations in the heat flow, and the output from the infrared detector thus varies with the amount of incident infrared rays. A conceivable method for solving this problem is a method in which the space between the support members and the electrodes is sufficiently increased for preventing heat of the infrared detection element 1 from escaping from the support members to the substrate so that even if the positional relationship between the support members and the electrodes is varied to some extent, the temperature of the infrared detection element is not affected by a positional variationship. However, this method has another problem of increasing the size of the infrared detector. Another method of forming a recess or hole for decreasing heat capacity and preventing escape of heat of the infrared detection element has the problem of complicating the shape of the substrate.

The prior art described in EP-A-0357002 concerns a pyroelectric infrared sensor comprising a substrate; an infrared detection element having a plate shape and made of a pyroelectric material; and support members made of a conductive paste, provided between a front surface of the substrate and the infrared detection element, for supporting the infrared detection element with a space between the infrared detection element and the substrate.

The present invention concerns a method of producing an infrared detector comprising the steps of:
applying a fluid organic compound containing an electrically conductive powder to an infrared detection element which has a plate shape, which comprises a pyroelectric material and which has electrodes formed on front and rear surfaces thereof by a screen-printing method;
solidifying the organic compound by heat treatment or drying so as to form support members electrically connected to the electrodes of the infrared detection element; and
securing the support members to a substrate,
said support members are formed having a height within the range of 0.2 to 0.3 mm.

Embodiments of this invention will now be described, by way of example, with reference to the accompanying drawings, of which:-
Fig. 1 is a sectional side view of an infrared detector manufactured in accordance with the present invention;
Fig. 2 is a plan view of an infrared detection element incorporated in the infrared detector of Fig. 1;
Fig. 3 is a plan view of an alternative infrared detection element;
Fig. 4 is a sectional side view of a conventional infrared detector; and
Fig. 5(a) and 5(b) are plan views of an infrared detection element which constitutes a conventional infrared detector.

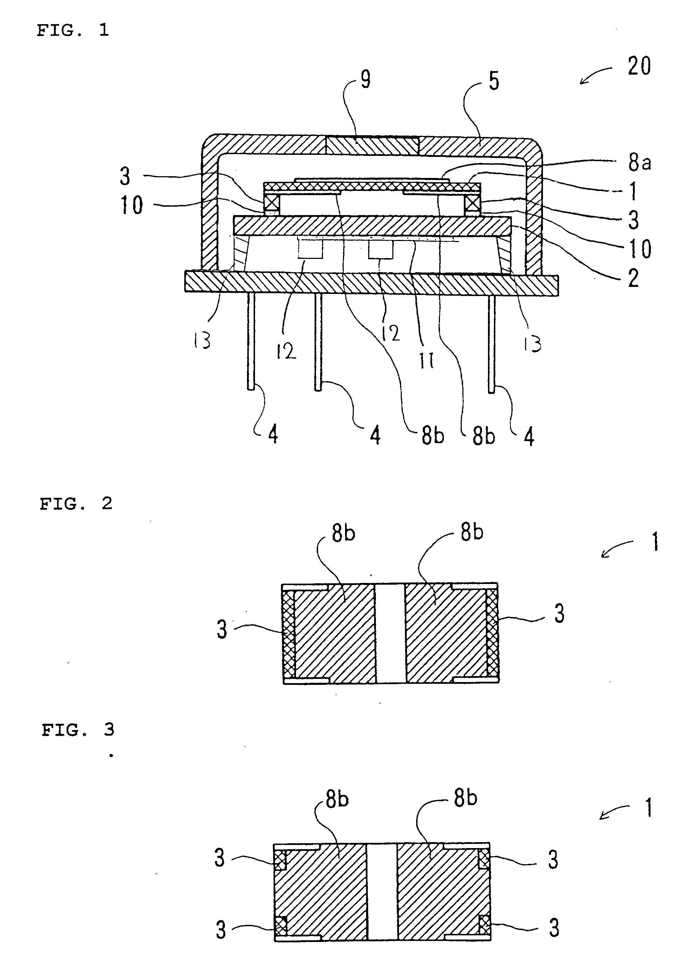

Fig. 1 is a sectional side view of the infrared detector 20, and Fig. 2 is a plan view showing the shape of the electrodes which are formed on the rear surface of an infrared detection element. Those elements similar to those in the conventional example of Figs. 4, 5(a) and 5(b) are denoted by the same reference numerals and not described below.

Referring to Figs. 1 and 2, the infrared detector 20 includes the infrared detection element 1 which is mounted on a front (upper in Fig. 1) surface of a substrate 2, and which is contained in a case 5 having a light transmitting window 9.

An electrode 8a (Fig. 5(a)) is formed on the front surface of the infrared detection element 1 which faces the light transmitting window 9. Electrodes 8b (Fig. 5(b)) are formed on the rear surface of the infrared detection element 1. As shown in Fig. 2, the support members 3, made of an organic compound containing an electrically conductive powder, are formed on portions of the electrodes 8b so as to be electrically connected with the electrodes 8b. Connecting portions 10 are respectively provided on portions of the substrate 2 intended to receive the support members 3. The electrodes 8a and 8b of the infrared detection element 1 are electrically connected to the output leads 4 through the support members 3.

The infrared detector 20 also includes a detection circuit consisting of circuit pattern 11 formed on the rear surface of the substrate 2 and electronic components 12 formed on the circuit pattern 11. As is apparent from Fig. 1, since the electronic components 12 are formed on the rear surface of the substrate 2, the distance between the infrared detection element 1 and the substrate can be reduced. The distance between the infrared detection element 1 is preferably about 0.1 mm or more, and more preferably in the range from about 0.2 mm to 0.3 mm. The substrate 2 is supported with supports 13 and fixed in the case 5.

The method of producing the infrared detector 20 according to the present invention will now be described.

The electrodes 8a and 8b are formed on the infrared detection element 1 having a plate shape and pyroelectric characteristics, by a sputtering and dry etching process. As shown in Fig. 2, the support members 3 are formed so as to be electrically connected to the electrodes 8b of the infrared detection element 1. The support members 3 are formed by applying conductive paste to the electrodes 8b through a screen-printing method and then heating the paste at about 110°C for 1 hour to dry and solidify it.

The connecting portions 10 are also formed on the substrate 2 by applying conductive paste through a screen-printing method. The infrared detection element 1 is connected to the connecting portions 10 of the substrate 2 by using conductive paste through the support members 3. The support members 3 are electrically connected to the infrared detection element 1 and contained in the case 5 together with the substrate 2 on which a detection circuit including circuit pattern 11 and electronic components 12 has been formed, to complete the infrared detector 20.

Since the support members 3 of the infrared detection element 1 are formed by the screen printing process, as described above, the support members 3 can be accurately positioned. This is because such a screen-printing method achieves precise alignment. The height of the support members 3 can be increased by performing a plurality of printing steps and dry solidification steps.

Although, in this embodiment, the support members 3 are respectively formed at both ends of the infrared detection element 1, the support members 3 may be formed at four positions, as shown in Fig. 3.

As long as the material used for forming the support members 3 has fluidity, is printable and exhibits electrical conductivity after being solidified, the material is not limited to conductive paste, and various fluid organic compounds containing electrically conductive powder can be used. An example of materials which can be used forming such fluid organic compounds and providing electrical conductivity comprise at least one metal selected from gold, silver, nickel, copper and solder; or at least one ceramic selected from carbon, conductive metal oxides and conductive metal carbides.

The substrate 2 may be formed by using ceramic such as alumina, glass epoxy resin, phenolic resin or the like.

Since the infrared detector manufactured according to the present invention comprises the support members for the infrared detection element which are formed by using an organic compound containing an electrically conductive powder, the support members can be formed by printing on the infrared detection element and then solidifying, thereby accurately maintaining the positional relationship between the infrared detection element and the support members. Thus, the heat flow which flows from the infrared detection element to the support members is constant, thereby preventing the output from the infrared detector from changing.

## Claims

1. A method of producing an infrared detector comprising the steps of:
applying a fluid organic compound containing an electrically conductive powder to an infrared detection element (1) which has a plate shape, which comprises a pyroelectric material and which has electrodes (8a, 8b) formed on front and rear surfaces thereof by a screen-printing method;
solidifying the organic compound by heat treatment or drying so as to form support members (3) electrically connected to the electrodes (8a, 8b) of the infrared detection element (1); and
securing the support members (1) to a substrate (2),
said support members (3) are formed having a height within the range of 0.2 to 0.3 mm.

2. A method of producing an infrared detector according to claim 1, further comprising the step of forming a detection circuit on a rear surface of the substrate, the detection circuit including a circuit pattern (11) and electronic components (12) provided on the circuit pattern (11).

## Patentansprüche

1. Ein Verfahren zum Herstellen eines Infrarotdetektors, das folgende Schritte aufweist:
Aufbringen einer fluidartigen organischen Verbindung, die ein elektrisch leitfähiges Pulver beinhaltet, auf ein Infraroterfassungselement (1), das die Form einer Platte aufweist, das ein pyroelektrisches Material aufweist und das Elektroden (8a, 8b) aufweist, die auf einer vorderen und einer hinteren Oberfläche desselben durch ein Siebdruckverfahren ausgebildet sind;
Verfestigen der organischen Verbindung durch eine Wärmebehandlung oder ein Trocknen, um Halteelemente (3) auszubilden, die mit den Elektroden (8a, 8b) des Infraroterfassungselements (1) elektrisch verbunden sind; und
Befestigen der Halteelemente (1) an einem Substrat (2),
wobei die Halteelemente (3) ausgebildet sind, um eine Höhe innerhalb des Bereichs von 0,2 bis 0,3 mm aufzuweisen.

2. Ein Verfahren zum Herstellen eines Infrarotdetektors gemäß Anspruch 1, das ferner den Schritt des Ausbildens einer Erfassungsschaltung auf einer hinteren Oberfläche des Substrats aufweist, wobei die Erfassungsschaltung eine Schaltungsstruktur (11) und elektronische Komponenten (12), welche auf der Schaltungsstruktur (11) vorgesehen sind, umfaßt.

## Revendications

1. Procédé de production d'un détecteur infrarouge comprenant les étapes consistant à:
appliquer un composé organique fluide contenant une poudre électriquement conductrice à un élément de détection infrarouge (1) en forme de plaque, qui comprend un matériau pyroélectrique et qui possède des électrodes (8a, 8b) formées sur les surfaces avant et arrière de celui-ci par un procédé sérigraphique;
solidifier le composé organique par un traitement à chaud ou séchage de façon à former des éléments de support (3) électriquement connectés aux électrodes (8a, 8b) de l'élément de détection infrarouge (1); et
fixer les éléments de support (3) sur un substrat (2),
lesdits éléments de support (3) ayant une forme présentant une hauteur se situant à l'intérieur de la plage comprise entre 0,2 et 0,3 mm.

2. Procédé de production d'un détecteur infrarouge selon la revendication 1, comprenant de plus l'étape consistant à former un circuit de détection sur une surface arrière du substrat, le circuit de détection incluant un tracé de circuit (11) et des composants électroniques (12) prévus sur le tracé de circuit (11).
